# EUROPÄISCHE PATENTSCHRIFT

(11) **EP 3 333 656 B1**
(45) Veröffentlichungstag und Bekanntmachung des Hinweises auf die Patenterteilung: **23.06.2021**
(21) Anmeldenummer: 16202933.4
(22) Anmeldetag: 08.12.2016
(51) Int. Cl.: G05B 19/05, G01R 19/165

(54) **SCHALTUNGSANORDNUNG FÜR EINEN DIGITALEINGANG EINER PERIPHERIEBAUGRUPPE UND PERIPHERIEBAUGRUPPE**
CIRCUIT ARRANGEMENT FOR A DIGITAL INPUT OF A PERIPHERAL MODULE AND A PERIPHERAL MODULE
CIRCUITERIE POUR UNE ENTRÉE NUMÉRIQUE D'UN MODULE PÉRIPHÉRIQUE ET MODULE PÉRIPHÉRIQUE

(43) Veröffentlichungstag der Anmeldung: 13.06.2018
(73) Patentinhaber: Siemens Aktiengesellschaft, 80333 München (DE)
(72) Erfinder: Grosser, Stefan, 92253 Schnaittenbach (DE)

(56) Entgegenhaltungen:
- EP-A1- 1 770 456
- EP-A1- 1 770 457

## Beschreibung

Die Erfindung betrifft eine Schaltungsanordnung für einen Digitaleingang einer Peripheriebaugruppe, umfassend einen als Digitaleingang fungierenden Eingangsanschluss, einen Masseanschluss, wobei zwischen dem Eingangsanschluss und dem Masseanschluss ein Halbleiterschaltmittel zur Strombegrenzung eines Eingangsstroms angeordnet ist, eine Referenzspannungsquelle, welches zur Ansteuerung des Halbleiterschaltmittels mit einem Steuereingang des Halbleiterschaltmittels verbunden ist.

Des Weiteren betrifft die Erfindung eine Peripheriebaugruppe für ein Automatisierungsgerät, welche eine oben genannte Schaltungsanordnung aufweist.

Als Peripheriebaugruppe wird im Sinne der Erfindung jede Baugruppe oder jedes Modul in einem oder für ein Automatisierungsgerät bezeichnet, das zum Anschluss einer externen Peripherie, also z.B. Sensoren bestimmt und vorgesehen ist.

Automatisierungsgeräte der eingangs genannten Art, insbesondere in einer Ausführungsform als modulare Automatisierungsgeräte sind allgemein bekannt, z.B. in Form der Automatisierungsgeräte die von der Anmelderin unter der Marke SIMATIC angeboten werden. Aus diesen Automatisierungsgeräten sind auch als Einzelmodule ausgeführte Peripheriebaugruppen, insbesondere Eingabebaugruppen oder kombinierte Ein-/Ausgabebaugruppen als ein konkretes Beispiel für eine Peripheriebaugruppe bekannt.

Die Erfindung bezieht sich speziell auf eine Schaltungsanordnung mit mindestens einem als Digitaleingang fungierenden Eingangsanschluss für eine Peripheriebaugruppe. Bei einer solchen Schaltungsanordnung bzw. bei einer solchen Peripheriebaugruppe handelt es sich entsprechend um eine Peripheriebaugruppe mit Digitaleingabe-Funktionalität. Solche Baugruppen werden häufig mit einer Mehrzahl, z.B. 16 oder 32 Digitaleingängen ausgeführt und entsprechend als Digitaleingabebaugruppe bezeichnet. Die Digitaleingabebaugruppe ist also eine Sonderform einer Peripheriebaugruppe mit ausschließlich digitaler Eingabefunktionalität. Daneben können auch Mischformen, also z.B. Digitalein-/ausgabebaugruppen oder Digitaleingabe- und Analogeingabebaugruppe mit mindestens einen Digitaleingang aufweisen.

Die im Stand der Technik bekannten Digitaleingabebaugruppen basieren auf dem Prinzip, dass über einen Digitaleingang, also den mit dem Eingangsanschluss verknüpften Eingangskanal, bei aktiviertem, angeschlossenen Sensor ein Strom in die Baugruppe fließt. Im einfachsten Fall wird bei vorhandenem Stromfluss der Sensor als aktiviert erkannt. Entsprechend wird bei nicht vorhandenem Stromfluss der Sensor als deaktiviert erkannt. Es kann jedoch auch bei deaktiviertem Sensor ein Strom in die Baugruppe fließen, so dass üblicherweise der Status des Sensors an der Höhe einer Spannung erkannt wird, vorzugsweise anhand des Überschreitens bestimmter vorgegebener oder vorgebbarer Schwellwerte für die Spannungshöhe, die zum Treiben eines Stroms über den Eingangsanschluss erforderlich ist. Dieses Standardprinzip ist insoweit nicht ganz optimal, als durch den Eingangsstrom eine Verlustleistung innerhalb der Baugruppe entsteht. Bei, gemäß der IEC 61131-2, vorgegebenen Standards für Spannungs- und Stromwerte an Digitaleingängen (Typ 1: High-Signal im Spannungsbereich 15 V bis 30 V, Eingangsstrom bei High-Signal: Mindestens 2 mA; Typ 2: High-Signal im Spannungsbereich 11 V bis 30 V, Eingangsstrom bei High-Signal: 6 mA) beträgt die Verlustleistung an einem Eingangskanal des oben genannten zweiten Typs mindestens 30 V • 6 mA = 180 mW. Dabei variiert die Verlustleistung je nach elektrischer Schaltung des Eingangskanals bei einem mittels einer passiven Schaltung realisierten Eingangskanal kommt es zu einer Verlustleistung von 30 V • 16,4 mA = 492 mW. Das vorangehende Zahlenbeispiel (Verlustleistung: 180 mW) bezieht sich auf eine aktive Schaltung mit sogenannter Stromsenke.

Die oben exemplarisch ausgewiesene Verlustleistung entsteht zudem pro Eingangskanal. D.h. bei einer Baugruppe mit 32 Eingangskanälen summiert sich die Verlustleistung zu 32 V • 180 mW = 5,76 W bzw. 32 V • 492 mW = 15,74 W.

Aus den beiden europäischen Patentanmeldungen EP 1 770 456 A1 und EP 1 770 457 A1 sind die beschriebenen Peripheriebaugruppen, deren Schaltungsanordnung und die beschriebene Problematik bereits bekannt.

Bei den kleinen Abmessungen heutiger SPS-Systeme bzw. Automatisierungsgeräte können Verlustleistungen, wie sie bei Typ 2 Digitaleingängen entstehen, nicht abgeführt werden. Deshalb wird ein nach der Norm IEC 61131-2: 2007 Typ 3 Digitaleingang verwendet. Typ 3: High-Pegel bei > = 11 V (Stromaufnahme > = 2 mA), Low-Pegel bei < = 5 V.

Demnach wird das grundsätzliche Problem, dass Digitaleingänge Verlustleistung erzeugen, dadurch gelöst, dass die Stromaufnahme soweit reduziert wird, wie es die betreffende Norm zulässt (EN 61131-2). Eine reduzierte Stromaufnahme hat aber wiederum zur Folge, dass bei diesem reduzierten Strom eventuelle vorhandene Leitungskapazitäten nur langsam entladen werden. Die Leitungskapazitäten entstehen aus den zwischen einer Peripheriebaugruppe und dem Sensor geführten Anschlussleitungen. Mit dem reduzierten Entladen der Leitungskapazitäten ergibt sich das Problem, dass damit eine maximale Schalt- bzw. Signalfrequenz eingeschränkt ist.

Die Aufgabe der Erfindung liegt dementsprechend darin, eine baugruppenseitig anfallende Verlustleistung zu reduzieren, aber dennoch mögliche vorhandene Leitungskapazitäten schnell genug entladen zu können.

Die Erfindung schlägt zur Vermeidung oder zumindest zur Verminderung der oben genannten Nachteile und zur Lösung der oben genannten Aufgabe eine Schaltungsanordnung für einen Digitaleingang einer Peripheriebaugruppe vor, wobei diese Schaltungsanordnung einen als Digitaleingang fungierenden Eingangsanschluss, einen Masseanschluss, wobei zwischen dem Eingangsanschluss und dem Masseanschluss ein Halbleiterschaltmittel zur Strombegrenzung eines Eingangsstromes angeordnet ist, eine Referenzspannungsquelle aufweist, welche zur Ansteuerung des Halbleiterschaltmittels mit einem Steuereingang des Halbleiterschaltmittels verbunden ist, dabei ist ein Regelungsmittel vorhanden, welches ausgestaltet ist, abhängig von einer Eingangsspannung am Eingangsanschluss die Referenzspannungsquelle derart zu regeln, dass das Hauptleiterschaltmittel bei einem ersten Spannungswert für die Eingangsspannung den Eingangsstrom auf einen ersten Eingangsstrom einstellt und bei einem zweiten Spannungswert für die Eingangsspannung den Eingangsstrom auf einen zweiten Eingangsstrom einstellt, wobei der erste Spannungswert größer ist als der zweite Spannungswert und aufgrund des Regelungsmittels dadurch der erste Eingangsstrom kleiner ist als der zweite Eingangsstrom.

Mit der oben genannten Lösung wird ein Digitaleingang realisiert, der bei einer großen Eingangsspannung (30 V) möglichst wenig Strom "zieht" (2mA), damit die entstehende Verlustleistung gering bleibt und bei geringer Spannung (11 V) mehr Strom "zieht" (5,4 mA) damit die vorhandene Leitungskapazität rasch entladen wird und somit Signale mit hohen Schaltfrequenzen erfasst werden können.

In einer Ausgestaltungsvariante der Schaltungsanordnung ist das Halbleiterschaltmittel als ein erster Transistor mit einem Collector, einem Emitter und einer Basis ausgestaltet und die Basis ist mit dem Steuereingang verbunden und das Regelungsmittel weist einen zweiten Transistor mit einem Collector, einem Emitter und einer Basis auf, die Basis des zweiten Transistors ist über einen Spannungsteiler mit dem Collector des ersten Transistors verbunden und der Collector des zweiten Transistors ist mit dem Steuereingang verbunden.

Weiterhin ist es vorteilhaft, wenn die Referenzspannungsquelle durch einen weiteren Spannungsteiler gebildet ist.

Ebenfalls wird die Aufgabe durch eine Peripheriebaugruppe für ein Automatisierungsgerät mit einer Schaltungsanordnung nach einem der Ansprüche 1 bis 4 gelöst.

Erfindungsgemäß wird eine Strombegrenzung des Digitaleingangs abhängig von der Spannung am Digitaleingang geregelt, sodass die Verlustleistung möglichst gering bleibt. Der besondere Effekt ist, dass bei einer geringen Spannung am Digitaleingang ein großer Strom am Digitaleingang aufgenommen wird, und dass bei einer hohen Spannung am Digitaleingang ein geringer Strom aufgenommen wird. Damit wird erreicht, dass die Verlustleistung bei hoher Spannung am Digitaleingang möglichst gering gehalten wird, aber zusätzlich wird damit erreicht, dass bei geringer Spannung am Digitaleingang ein großer Strom aufgenommen wird. Bei dieser geringen Spannung und dem großen Strom liegt eine Verlustleistung damit ebenfalls in einem geringen Bereich. Insgesamt wird damit erreicht, dass Leitungskapazitäten durch die große Stromaufnahme relativ schnell entladen werden und somit auch Signale von sogenannten High-Side-Signalgebern schnell erfasst werden können.

Nachfolgend wird ein Ausführungsbeispiel der Erfindung anhand der Zeichnungen näher erläutert. Einander entsprechende Gegenstände und Elemente sind in allen Figuren mit den gleichen Bezugszeichen versehen. Darin zeigen:
- FIG 1: ein SPS-System mit einer Peripheriebaugruppe und einem angeschlossenen Signalgeber,
- FIG 2: ein Prinzip von Push-Pull-Signalgebern,
- FIG 4: eine Schaltungsanordnung für einen Digitaleingang nach dem Stand der Technik,
- FIG 5: Spannungs- und Stromverläufe der Schaltungsanordnung nach dem Stand der Technik,
- FIG 6: die erfindungsgemäße Schaltungsanordnung,
- FIG 7: Signalverläufe für Spannung und Strom der erfindungsgemäßen Schaltungsanordnung,
- FIG 8: ein praktischer Anwendungsfall,
- FIG 9: die Signalverläufe bei einer Schaltungsanordnung nach dem Stand der Technik,
- FIG 10: die Schaltungsanordnung mit einem praktischen Anwendungsfall bezüglich der Leitungskapazität und
- FIG 11: die Signalverläufe für Strom und Spannung mit der erfindungsgemäßen Schaltungsanordnung im praktischen Anwendungsfall.

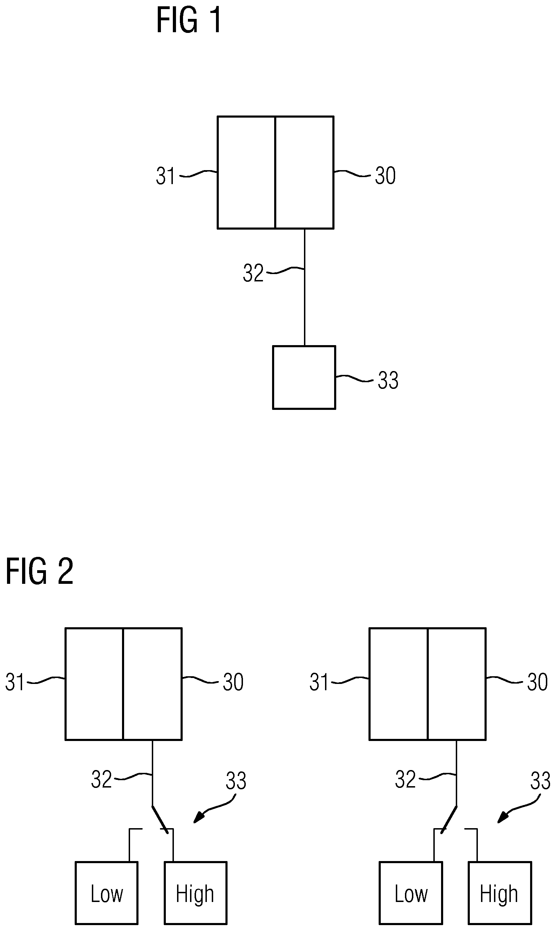

Gemäß FIG 1 ist ein SPS-System mit einem Automatisierungsgerät 31, einer Peripheriebaugruppe 30 mit einem über einen Anschlussleitung 32 angeschlossenen Signalgeber 33 dargestellt. Der Signalgeber 33 ist an der Peripheriebaugruppe 30 angeschlossen. Die Peripheriebaugruppe 30 ist als ein Digitaleingabemodul ausgestaltet. Die Anschlussleitung 32 hat, bedingt durch deren inneren Aufbau, eine bestimmte Kapazität, z.B. 100 pF/m. Bei vorhandenen Leitungskapazitäten der Anschlussleistung ergibt sich immer die Problematik des Entladens dieser Leitungskapazitäten, wodurch mögliche Schaltfrequenzen von Signalgebern eingeschränkt sein können. Es gibt "schnelle" Digitaleingabemodule die Schaltfrequenzen von z.B. 100 kHz erfassen können. Und es gibt prinzipiell zwei Typen von Signalgebern: Einen Push-Pull-Signalgeber und einen High-Side-Signalgeber.

FIG 2 zeigt einen Push-Pull-Signalgeber, welcher bei High-Pegel, z.B. 24 V und bei Low-Pegel z.B. 0 V ausgibt. Die Leitungskapazität wird sowohl bei einem High-Pegel, als auch bei einem Low-Pegel aktiv geladen bzw. entladen.

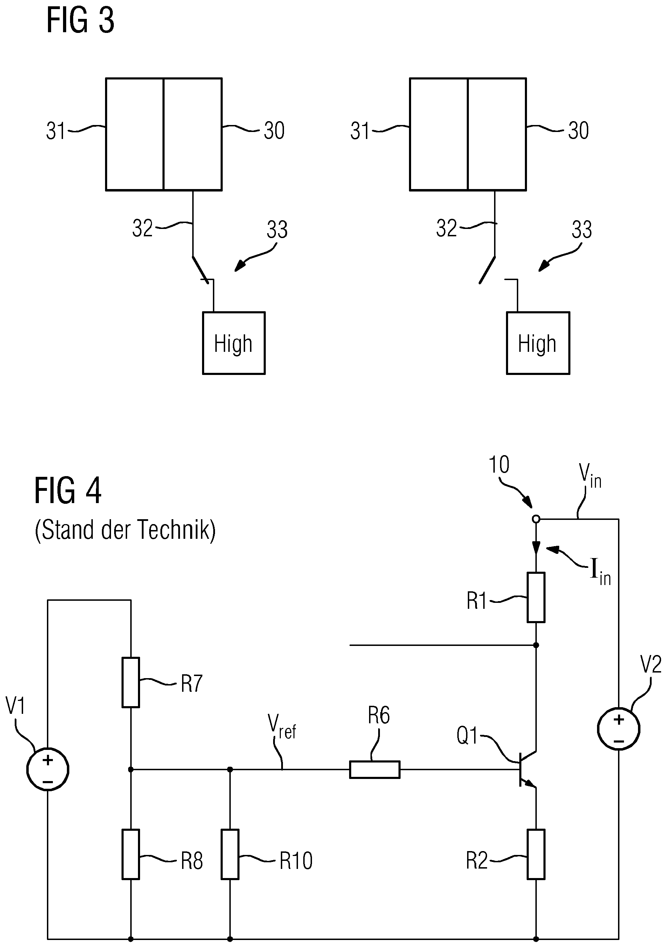

FIG 3 zeigt einen High-Side-Signalgeber bei einem High-Pegel ist der Schalter geschlossen und es werden z.B. 24 V ausgegeben. Bei einem Low-Pegel ist der Schalter geöffnet und es wird "nichts" ausgegeben. Der Signalgeber wird hochohmig. Die Leitungskapazität wird bei einem Wechsel von Low-Pegel zu High-Pegel aktiv geladen. Bei einem Wechsel von High-Pegel zu Low-Pegel muss sich die Leitungskapazität über das Digitaleingabemodul entladen. Bei Digitaleingängen mit großer Stromaufnahme geschieht dies relativ schnell. Bei Digitaleingängen mit einer geringen Stromaufnahme geschieht dies langsam. Das bedeutet, dass Digitaleingänge mit einer geringen Stromaufnahme lange brauchen bis die Leitungskapazität auf Low-Pegel entladen wird. Eine maximale Eingangsfrequenz bzw. Schaltfrequenz wird dadurch begrenzt. Die Norm IEC 61131-2: 2007 beschreibt drei Arten von Digitaleingängen Typ 1, Typ 2 und Typ 3. Darin werden folgende Werte angegeben: Typ 1: High-Pegel bei > = 15 V (Stromaufnahme > = 2 mA), Low-Pegel bei < = 5 Volt. Typ 2: High-Pegel bei > = 11 V (Stromaufnahme > = 6 mA), Low-Pegel bei < = 5 V. Typ 3: High-Pegel bei > = 11 V (Stromaufnahme > = 2 mA), Low-Pegel bei < = 5 V.

Hier wird nochmals das grundlegende Problem deutlich: Digitaleingänge vom Typ 2 nehmen 6mA auf, entladen die Leitungskapazität somit recht schnell. Bei 30 V Eingangsspannung verursachen sie aber eine Verlustleistung von 30 V • 6 mA = 180 mV. Bei einem Peripheriemodul bzw. bei einem Digitaleingabemodul mit 32 Eingängen wären das 32 • 180 mW = 5,76 W. Hingegen nehmen Digitaleingänge vom Typ 3 nur 2 mA auf, entladen dadurch die Leitungskapazität aber nur recht langsam. Bei 30 V Eingangsspannung verursachen sie dafür nur eine Verlustleistung von 30 V • 2 mA = 60 mW. Bei einem Digitaleingabemodul mit 32 Eingängen wären dies nur 32 • 180 mW = 1,92 W.

Bei den heutigen immer kleiner werdenden Abmessungen von SPS-Systemen bzw. Peripheriebaugruppen können Verlustleistungen wie sie bei Typ 2 Digitaleingängen entstehen nicht mehr abgeführt werden. Deshalb werden Typ 3 Digitaleingänge verwendet. Demnach wird erfindungsgemäß ein Digitaleingang realisiert, der bei einer großen Spannung (30 V) möglichst wenig Strom zieht (2 mA), damit die Verlustleistung gering bleibt und bei geringer Spannung (11 V) mehr Strom (5,4 mA) damit die Leitungskapazität auch rasch entladen wird und somit hohe Schaltfrequenzen möglich werden.

Gemäß FIG 4 ist eine Schaltungsanordnung nach dem Stand der Technik abgebildet. Eine Eingangsspannung Vᵢₙ liegt an einem Eingangsanschluss 10 an. Aus einer Versorgungsspannung V1 wird über einen Spannungsteiler R7,R8 eine Referenzspannungsquelle V_{Ref} erzeugt. Die Referenzspannung der Referenzspannungsquelle V_{Ref} liegt über einen Widerstand R6 an der Basis B1 eines ersten Transistors Q1. Mit einem Emitterwiderstand R2 wird eine Strombegrenzung erreicht. Die Dimensionierung der Bauteile ist in dem mit FIG 4 gezeigten Beispiel so, dass ein Eingangsstrom I in an dem Eingangsanschluss 10 auf ca. 2 mA begrenzt wird.

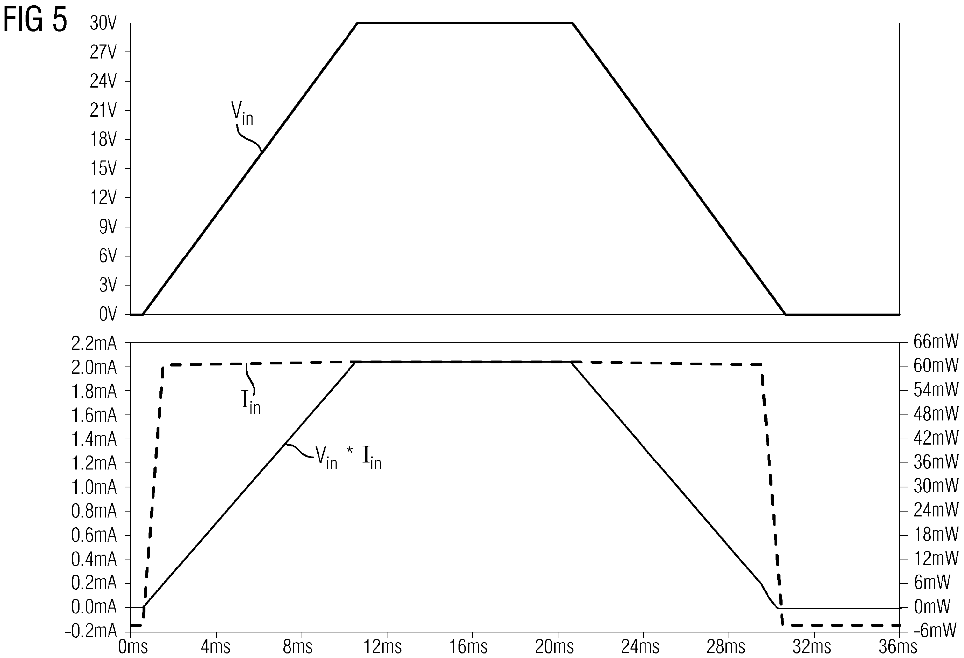

Mit der FIG 5 werden die zu FIG 4 zugehörigen Signalverläufe von Strom und Spannung gezeigt. Im oberen Diagramm ist die Eingangsspannung Vᵢₙ aufgezeichnet. Die Eingangsspannung Vᵢₙ steigt von 0 V auf 30 V und fällt dann wieder von 30 V auf 0 V. Im unteren Diagramm ist dazu der Eingangsstrom Iᵢₙ und die zugehörige Verlustleistung Vᵢₙ • Iᵢₙ aufgezeigt. Bei 30 V für eine Eingangsspannung Vᵢₙ erhält man eine Verlustleistung von etwa 60 mW.

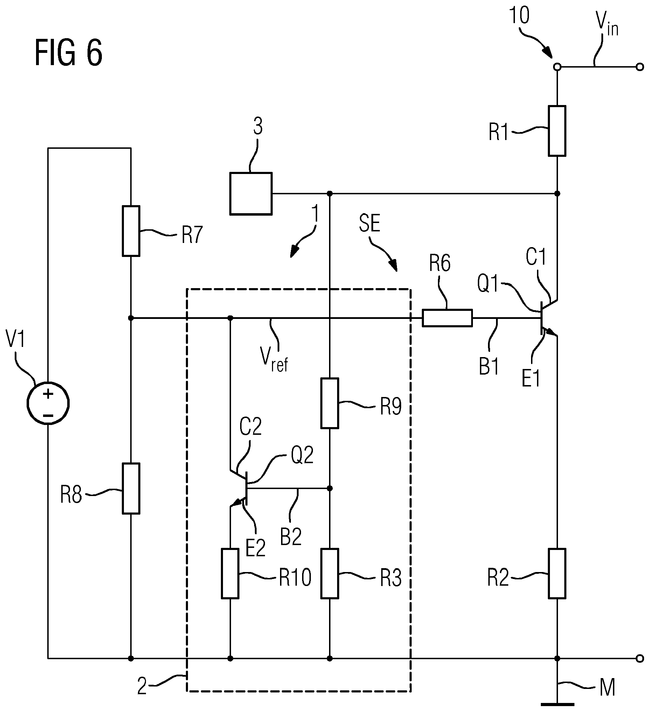

Die FIG 6 zeigt die ergänzte Schaltungsanordnung 1 mit dem erfindungsgemäßen Regelungsmittel 2. Zu der Schaltungsanordnung aus FIG 4 wurde zusätzlich ein zweiter Transistor Q2 ergänzt. Er wird über einen weiteren Spannungsteiler R9,R3 zum Collector C1 des ersten Transistors Q1 verbunden. Die Referenzspannung der Referenzspannungsquelle V_{Ref} wird wieder über den Spannungsteiler R7,R8 erzeugt. Sobald der zweite Transistor Q2 leitend wird, wird zunehmend eine Parallelschaltung der Widerstände R8 und R10 erreicht. Damit wird die Referenzspannung der Referenzspannungsquelle V_{Ref} reduziert. Die Reduzierung der Referenzspannung der Referenzspannungsquelle V_{Ref} führt dazu, dass wegen der Gegenkopplung mit dem Emitterwiderstand R2 des ersten Transistors Q1 auch der Collectorstrom durch den ersten Transistor Q1 reduziert wird. Damit wird der Eingangsstrom Iᵢₙ automatisch begrenzt. Bei einer geringen Eingangsspannung Vᵢₙ wird über den Eingangsanschluss 10 ein hoher Strom aufgenommen. Bei einer hohen Eingangsspannung Vᵢₙ wird ein geringer Strom aufgenommen.

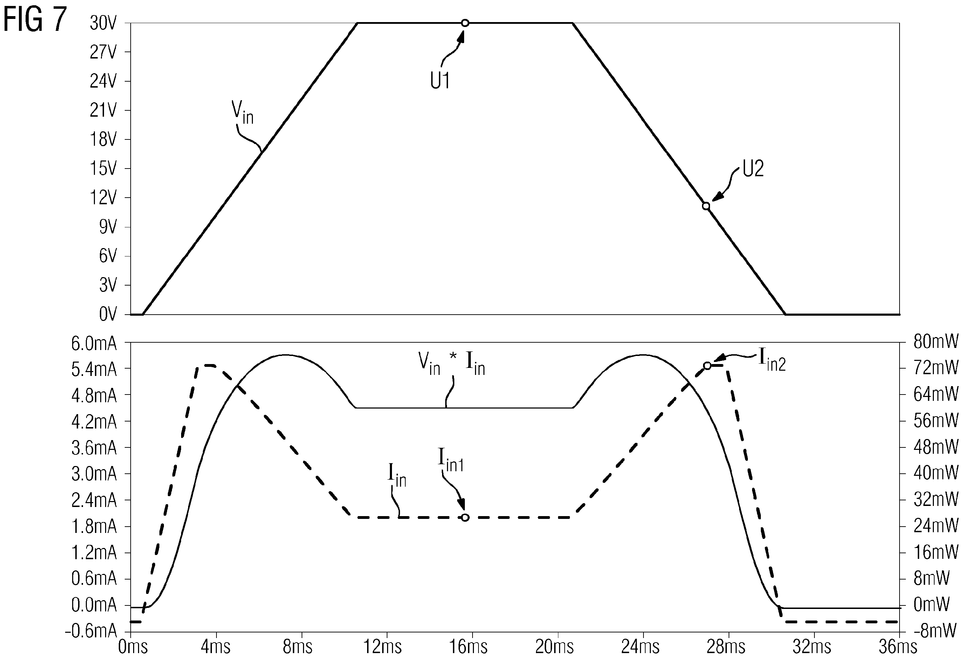

Mit der FIG 7 sind die Signalverläufe von Strom und Spannung gemäß der Schaltungsanordnung nach FIG 6 dargestellt. Im Diagramm oben ist die Eingangsspannung Vᵢₙ aufgezeichnet. Die Eingangsspannung Vᵢₙ steigt von 0 V auf 30 V und fällt dann wieder von 30 V auf 0 V. Die 30 V könnten einem ersten Spannungswert U1 entsprechen und beispielsweise ca. 10 V könnten einem zweiten Spannungswert U2 entsprechen. Im unteren Diagramm ist dazu der zugehörige Eingangsstrom Iᵢₙ und die entstehende Verlustleistung Vᵢₙ • Iᵢₙ aufgezeigt. Der Eingangsstrom Iᵢₙ steigt mit steigender Eingangsspannung Vᵢₙ zunächst stark an (bis etwa 5,4 mA) und wird dann mit weiter steigender Eingangsspannung Vᵢₙ auf einen ersten Eingangsstrom Iᵢₙ₁ (etwa 2 mA) zurückgeregelt. Bei einer Eingangsspannung Vᵢₙ von ca. 30 V erhält man damit wieder eine Verlustleistung von etwa 60 mW. Fällt die Eingangsspannung Vᵢₙ wieder von ihrem Maximalwert 30 V, so wird der Strom wieder hochgeregelt, wobei man sagen kann, zu dem ersten Spannungswert U1 wird ein erster Eingangsstrom Iᵢₙ und zu dem zweiten Spannungswert U2 gehört ein zweiter Eingangsstrom Iᵢₙ₂. Demnach wird mit der Schaltungsanordnung gemäß FIG 6, wobei der eingekreiste Bereich das Regelungsmittel 2 darstellt, derart geregelt, dass der erste Transistor Q1 bei einem ersten Spannungswert U1 für die Eingangsspannung Vᵢₙ den Eingangsstrom Iᵢₙ auf einen ersten Eingangsstrom Iᵢₙ₁ einstellt und bei einem zweiten Spannungswert U2 für die Eingangsspannung Vᵢₙ den Eingangsstrom Iᵢₙ auf einen zweiten Eingangsstrom Iᵢₙ₂ einstellt, wobei der erste Spannungswert U1 größer ist als der zweite Spannungswert U2 und aufgrund des Regelungsmittels 2 dadurch der erste Eingangsstrom Iᵢₙ₁ kleiner ist als der zweite Eingangsstrom Iᵢₙ₂.

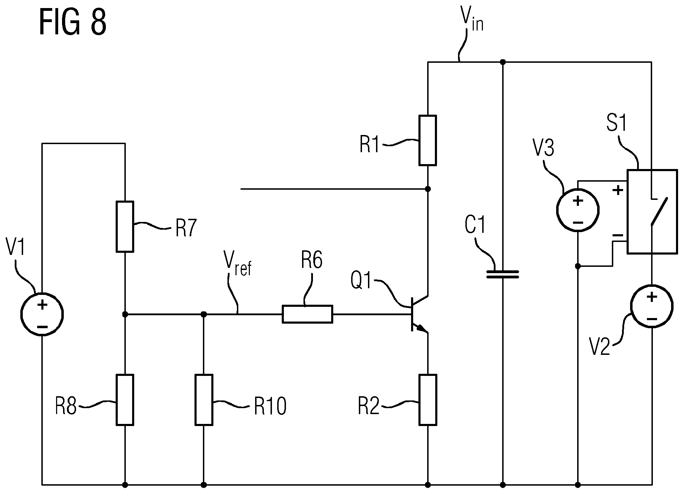

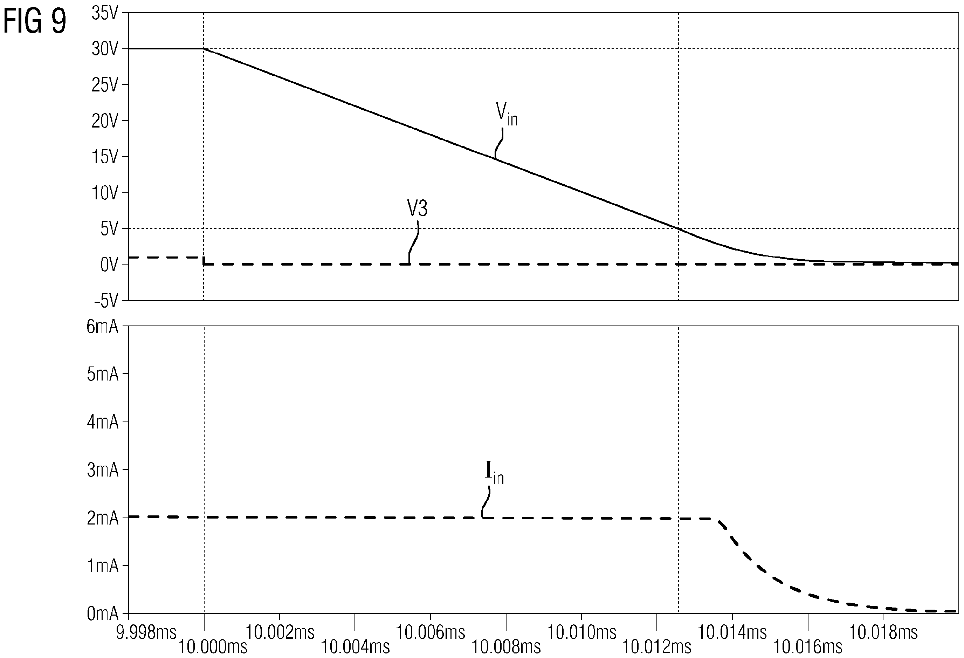

Gemäß FIG 8 wird zur Verdeutlichung an die Schaltungsanordnung nach dem Stand der Technik ein Anwendungsfall angeschlossen, welcher eine Leitungskapazität C1 und einen High-Side-Schalter S1 simuliert. Die Leitungskapazität C1 hat beispielsweise einen Wert von C1 = 1nF. Über den High-Side-Schalter S1 wird eine Spannung V2 (30 V) zugeschaltet und dann wieder abgeschaltet. Eine Abschaltung erfolgt wie in den Spannungsverläufen gemäß FIG 9 zu sehen, bei t = 10,0 ms.

Demnach zeigt die FIG 9 die Signalverläufe für Strom und Spannung bei einer Schaltungsanordnung nach dem Stand der Technik. Bei t = 10,0 ms wird der Schalter S1 geöffnet und damit die Schaltspannung V3 für den Schalter S1 gegen Null gehen. Im oberen Diagramm ist zu sehen, dass die Eingangsspannung Vᵢₙ etwa linear abfällt, da der Kondensator C1 mit einem konstanten Strom von etwa 2 mA entladen wird. Ist die Eingangsspannung Vᵢₙ bei einem Wert von 5 V angekommen, kann der Signaleingang sicher einen Low-Pegel erkennen. Die Zeit, bis die Eingangsspannung Vᵢₙ von 30 V auf 5 V gefallen ist, ist mit den gestrichelten Linien markiert und beträgt etwa 12,6 µs. D.h. erst etwa 12,6 µs nach dem Öffnen des Schalters S1 erkennt der Digitaleingang einen Low-Pegel.

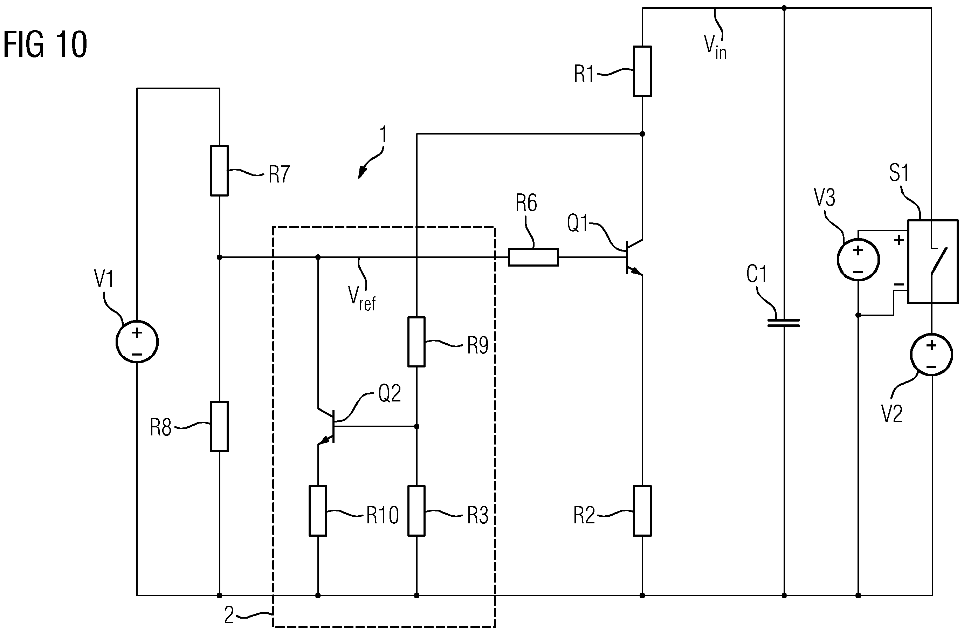

Um den Unterschied aufzuzeigen, wird gemäß FIG 10 der praktische Anwendungsfall an der erfindungsgemäßen Schaltungsanordnung 1 ebenfalls durchgeführt. Nun weist die Schaltungsanordnung wieder das Regelungsmittel 2 auf. Am Eingangsanschluss 10 ist wiederum die Leitungskapazität von C1 angeordnet. Über einen High-Side-Schalter S1 wird die Spannung V2 von 30 V zugeschaltet, der Schalter S1 wird mit einer Steuerspannung V3 geschaltet.

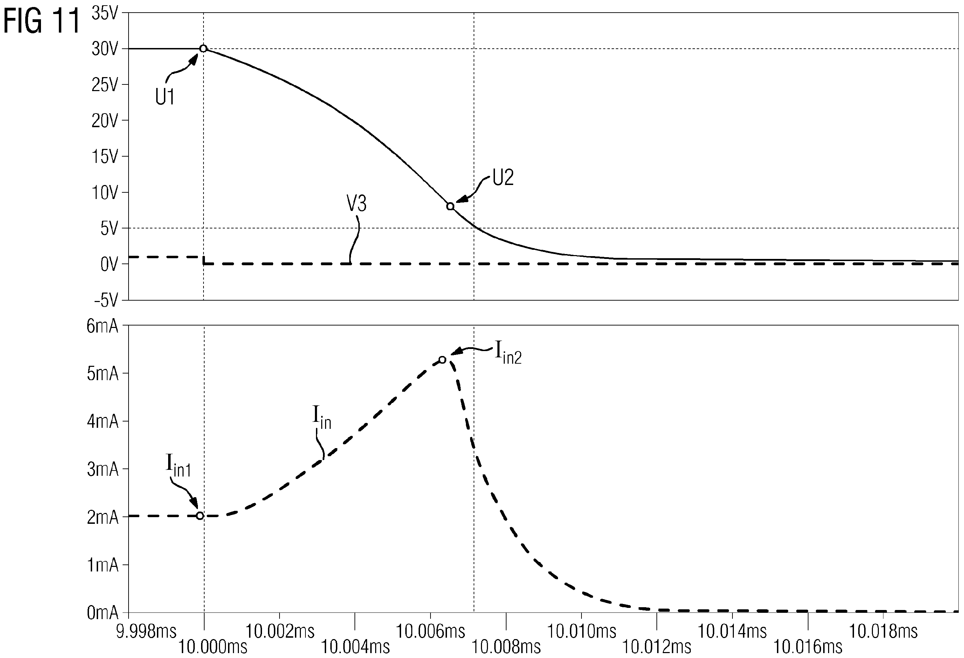

Die FIG 11 zeigt letztendlich die Signalverläufe bei einem realen Anwendungsfall gemäß der erfindungsgemäßen Schaltungsanordnung 1. Nach dem Abschalten des Schalters S1 mit der Schaltspannung V3 fällt die Eingangsspannung Vᵢₙ von einem ersten Spannungswert U1 = 30 V auf einen zweiten Spannungswert U2 von ungefähr 10 V. Die Eingangsspannung Vᵢₙ fällt nun zunehmend steiler ab, da der Kondensator C1 mit einem steigenden Strom entladen wird. Der Eingangsstrom Iᵢₙ steigt nach dem Abschalten aufgrund des Regelungsmittels 2 anfangs von ca. 2 mA rasch auf etwa 5,4 mA an. Durch diesen regelungstechnisch bedingten Anstieg von dem ersten Eingangsstrom Iᵢₙ₁ auf den zweiten Eingangsstrom Iᵢₙ₂ kann die Leitungskapazität C1 schneller entladen werden und bereits nach einer Zeit ebenfalls mit gestrichelten Linien markiert, von ca. 7,2 µs kann der Digitaleingang sicher einen Low-Pegel erkennen. Bei der erfindungsgemäßen Schaltanordnung wird demnach ein Low-Pegel bereits nach 7,2 µs statt nach 12,6 µs erkannt, somit können auch mit High-Side-Signalgebern hohe Schaltfrequenzen erreicht werden.

Die Pegelerkennung (High-Pegel/Low-Pegel) wird in der Regel mit einem Komparator realisiert, der die Eingangsspannung Vᵢₙ erfasst. In der FIG 6 wurde ein Pegelerkennungsmittel 3 eingezeichnet um zu verdeutlichen, dass eine derartige Pegelerkennung natürlich grundsätzlich vorhanden ist.

## Patentansprüche

1. Schaltungsanordnung (1) für einen Digitaleingang einer elektronischen Peripheriebaugruppe (30), umfassend:
- einen als Digitaleingang fungierenden Eingangsanschluss (10),
- einen Masseanschluss (M), wobei zwischen dem Eingangsanschluss (10) und dem Masseanschluss (M) ein Halbleiterschaltmittel zur Strombegrenzung eines Eingangsstroms (I-in) angeordnet ist,
- eine Referenzspannungsquelle (V_{ref}), welche zur Ansteuerung des Halbleiterschaltmittels mit einem Steuereingang (SE) des Halbleiterschaltmittels verbunden ist,
**dadurch gekennzeichnet, dass**
ein Regelungsmittel (2) vorhanden ist, welches ausgestaltet ist, abhängig von einer Eingangsspannung (Vᵢₙ) am Eingangsanschluss (10), die Referenzspannungsquelle (V_{ref}) derart zu regeln, dass das Halbleiterschaltmittel bei einem ersten Spannungswert(U1) für die Eingangsspannung (Vᵢₙ) den Eingangsstrom (Iᵢₙ) auf einen ersten Eingangsstrom (Iᵢₙ₁) einstellt und bei einem zweiten Spannungswert (U2) für die Eingangsspannung (Vᵢₙ) den Eingangsstrom (Iᵢₙ) auf einen zweiten Eingangsstrom (Iᵢₙ₂) einstellt, wobei der erste Spannungswert (U1) größer ist als der zweite Spannungswert (U2) und aufgrund des Regelungsmittels (2) dadurch der erste Eingangsstrom (Iᵢₙ₁) kleiner ist als der zweite Eingangsstrom (Iᵢₙ₂).

2. Schaltungsanordnung (1) nach Anspruch 1, wobei das Halbleiterschaltmittel als ein erster Transistor (Q1) mit einem Collector (C1), einem Emitter (E1) und einer Basis (B1) ausgestaltet ist und die Basis (B1) mit dem Steuereingang (SE) verbunden ist und das Regelungsmittel (2) einen zweiten Transistor (Q2) mit einem Collector (C2), einem Emitter (E2) und einer Basis (B2) aufweist, die Basis (B2) des zweiten Transistors (Q2) ist über einen Spannungsteiler (R9,R3) mit dem Collector (C1) des ersten Transistors (Q1) verbunden und der Collector (C2) des zweiten Transistors (Q2) ist mit dem Steuereingang (SE) verbunden.

3. Schaltungsanordnung (1) nach Anspruch 1 oder 2, wobei die Referenzspannungsquelle (V_{ref}) durch einen weiteren Spannungsteiler (R7,R8) gebildet ist.

4. Schaltungsanordnung (1) nach einem der Ansprüche 1 bis 3, aufweisend ein Mittel zur Pegelerkennung, welches an dem Eingangsanschluss (10) angeschlossen ist.

5. Peripheriebaugruppe (30) für ein Automatisierungsgerät (31) mit einer Schaltungsanordnung (1) nach einem der Ansprüche 1 bis 4.

## Claims

1. Circuit arrangement (1) for a digital input of an electronic peripheral module (30), comprising:
- an inlet connection (10) acting as a digital input,
- a ground connection (M), wherein a semiconductor switching device to limit the current of an input current (Iᵢₙ) is arranged between the inlet connection (10) and the ground connection (M),
- a reference voltage source (V_{ref}) which is connected to a control input (SE) of the semiconductor switching device to control the semiconductor switching device,
**characterised in that**
there is a regulation means (2) which is designed, depending on an input voltage (Vᵢₙ) at the inlet connection (10), to regulate the reference voltage source (V_{ref}) such that for a first voltage value (U1) the semiconductor switching device adjusts the input current (Iᵢₙ) for the input voltage (Vᵢₙ) to a first input current (Iᵢₙ₁) and for a second voltage value (U2) adjusts the input current (Iᵢₙ) for the input voltage (Vᵢₙ) to a second input current (Iᵢₙ₂), wherein the first voltage value (U1) is greater than the second voltage value (U2) and the first input current (Iᵢₙ₁) is consequently smaller than the second input current (Iᵢₙ₂) on account of the regulation means (2) .

2. Circuit arrangement (1) according to claim 1, wherein the semiconductor switching device is designed as a first transistor (Q1) with a collector (C1), an emitter (E1) and a base (B1) and the base (B1) is connected to the control input (SE) and the regulation means (2) has a second transistor (Q2) with a collector (C2), an emitter (E2) and a base (B2), the base (B2) of the second transistor (Q2) is connected to the collector (C1) of the first transistor (Q1) by way of a voltage divider (R9, R3) and the collector (C2) of the second transistor (Q2) is connected to the control input (SE).

3. Circuit arrangement (1) according to claim 1 or 2, wherein the reference voltage source (V_{ref}) is formed by a further voltage divider (R7, R8).

4. Circuit arrangement (1) according to one of claims 1 to 3, having a means for level detection which is connected to the inlet connection (10).

5. Peripheral module (30) for an automation device (31) with a circuit arrangement (1) according to one of claims 1 to 4.

## Revendications

1. Montage (1) d'une entrée numérique d'un module (30) électronique périphérique, comprenant :
- une borne (10) d'entrée servant d'entrée numérique,
- une borne (M) de masse, un moyen de coupure à semi-conducteur pour limiter un courant (I-in) d'entrée étant disposé entre la borne (10) d'entrée et la borne (M) de masse,
- une source (V_{ref}) de tension de référence, qui, pour commander le moyen d'interruption à semi-conducteur, est reliée à une entrée (SE) de commande du moyen de coupure à semi-conducteur,
**caractérisé en ce que**
il y a un moyen (2) de régulation qui est conformé pour, en fonction d'une tension (Vᵢₙ) d'entrée à la borne (10) d'entrée, réguler la source (V_{ref}) de tension de référence de manière à ce que le moyen de coupure à semi-conducteur établisse pour une première valeur (U1) de la tension (Vᵢₙ) d'entrée le courant (Iᵢₙ) d'entrée à un premier courant (Iᵢₙ₁) d'entrée et établisse pour une deuxième valeur (U2) de la tension (Vᵢₙ) d'entrée le courant (Iᵢₙ) d'entrée à un deuxième courant (Iᵢₙ₂) d'entrée, la première valeur (U1) de tension étant plus haute que la deuxième valeur (U2) de tension et, en raison du moyen (2) de régulation, le premier courant (Iᵢₙ₁) d'entrée étant ainsi plus petit que le deuxième courant (Iᵢₙ₂) d'entrée.

2. Montage (1) suivant la revendication 1, dans lequel le moyen de coupure à semi-conducteur est conformé sous la forme d'un premier transistor (Q1) ayant un collecteur (C1), un émetteur (E1) et une base (B1) et la base (B1) est reliée à l'entrée (SE) de commande et le moyen (2) de régulation a un deuxième transistor (Q2) ayant un collecteur (C2), un émetteur (E2) et une base (B2), la base (B2) du deuxième transistor (Q2) est, par un diviseur (R9, R3) de tension, reliée au collecteur (C1) du premier transistor (Q1) et le collecteur (C2) du deuxième transistor (Q2) est relié à l'entrée (SE) de commande.

3. Montage (1) suivant la revendication 1 ou 2, dans lequel la source (V_{ref}) de tension de référence est formée d'un autre diviseur (R7, R8) de tension.

4. Montage (1) suivant l'une des revendications 1 à 3, comportant un moyen de détection de niveau, qui est connecté à la borne (10) d'entrée.

5. Module (30) périphérique d'un appareil (31) d'automatisation, ayant un montage (1) suivant l'une des revendications 1 à 4.
